(19) Europäisches Patentamt

European Patent Office

Office européen des brevets

(11) **EP 1 065 856 A2**

(12) **EUROPEAN PATENT APPLICATION**

(43) Date of publication:
**03.01.2001 Bulletin 2001/01**

(51) Int. Cl.[7]: **H04L 27/36**, H04L 25/03,
H03F 3/32, H04B 1/04

(21) Application number: **00830422.2**

(22) Date of filing: **15.06.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **17.06.1999 IT MC990051**

(71) Applicant: **Itelco - S.p.A.
Orvieto (TR) (IT)**

(72) Inventors:
• **Andreoli, Sante**
  **Pescara (IT)**
• **Banelli, Paolo**
  **Perugia (IT)**

(74) Representative: **Baldi, Claudio
Piazza Ghislieri, 3
60035 Jesi (Ancona) (IT)**

(54) **Baseband predistortion system for linearising power amplifiers.**

(57) The present invention concerns a predistortion system for amplifier linearisation characterised by the fact that it comprises a predistortion circuit in cascade to a clipping circuit composed of at least one clipping device followed by at least one post-clipping filter device.

Fig. 1(a)

**EP 1 065 856 A2**

**Description**

The present patent application for industrial invention concerns a predistortion system used to linearise amplifiers that exhibit non-linear distortion phenomena. An instantaneous non-linear amplifier can be generally modelled through its AM/AM and AM/PM distortion curves [1], [2].

Both types of non-linear distortion produce the spectral regrowth of the amplifier output. The spectral regrowth can be classified into the two following categories:

- In-band intermodulations
- Out-band intermodulations.

In-band intermodulations cannot be eliminated with linear filtering and are responsible for the signal-to-noise ratio degradation and, consequently, for the Bit Error Rate (BER) degradation in digital communication systems.

Out-band intermodulations generate the interference between adjacent channels and can be filtered out at the amplifier output, although with a certain output power penalty due to filter insertion losses.

Baseband predistortion is one of the known techniques used to counteract AM/AM and AM/PM distortions [2][3] and its digital adaptive implementation has been widely investigated in the last few years [4] [5] [6] [7].

However, because of its limited maximum output power, even an ideally predistorted amplifier can be modelled as a device (hereinafter called "soft-limiter") that limits the signal envelope below a certain maximum value.

Consequently, the saturation non linear distortion cannot be avoided whenever the signal modulation is characterised by a non constant envelope and the amplifier does not work with an adequate difference between the maximum and the mean output power. This situation is typical of multicarrier signals, which are characterised by a high peak-to-mean power ratio. Consequently, their maximum signal envelope is usually reduced with an operation (defined as "clipping") in order to obtain a more efficient power amplification, even if paying the price of a reduced spectral purity. The difference between the maximum and the working amplifier output power is commonly defined as "back-off".

The aim of the present invention is to realise a predistortion system to linearise non linear amplifiers in such a way as to reduce the complexity and cost of, or even to eliminate, the amplifier output filters that are used to reduce the out-band spectral regrowth.

None of the known predistortion systems considers the clipping phenomenon in detail as an integral part of the predistortion process.

The invention consists in combining the predistorting action with the signal pre-clipping in order to avoid or reduce both other clipping phenomena and the amplifier saturation, at the same allowing for filtering the out-band intermodulations produced by the clipping action itself.

The object is achieved through the predistortion system according to the present invention, which includes a predistortion circuit, a clipping circuit to reduce the peak-to-mean power ratio of the signal and a device for filtering the spectral regrowth produced by the clipping circuit itself.

The term "pre-clipping" is used to point out that the clipping operation has to be performed before predistortion.

The second aim of the invention is to provide adaptation to the predistortion system.

The second object is achieved by the present invention including both an input-output error circuit that provides the values to modify the action of the predistortion circuit and a timing circuit to synchronise the input to the output of the system in the predistortion system.

Following are some considerations to better understand the reasons why clipping is introduced before the predistortion circuit:

- both the predistortion circuit and the RF amplifier introduce non linear distortions (i.e. AM/AM and AM/PM) that only depend on the baseband signal envelope and, consequently, on the instantaneous signal power;
- the ideal combination of the predistortion circuit with the amplifier gives rise to an overall system that is characterised by a completely cancelled AM/PM curve and a residual AM/AM curve that acts as soft limiter of the baseband signal envelope.

This means that the RF output of the ideally predistorted amplifier is equivalent to the RF modulation of a complex baseband signal, whose envelope is passed through a soft limiter device.

The residual distortion introduced by the soft limiter depends on the signal peak-to-mean power ratio and on the input back off to the predistorted system (soft limiter).

A residual distortion is introduced whenever the input back-off to the predistorted system is lower than the peak-to-mean power ratio of the signal.

Distortions become as more evident as the input signal is characterised by a high peak-to-mean power ratio.

If the predistorted amplifier introduces some clipping on the signal envelope, the consequent spectral regrowth will degrade the signal both with respect to the signal-to-noise ratio and the adjacent channel interference.

The signal-to-noise ratio degradation for a fixed input back-off cannot be avoided since it depends on the in-band intermodulations.

On the contrary, the linear filtering of the out-band intermodulations produced by clipping can reduce the adjacent channel interference.

If the predistorted amplifier generates clipping, the only way to reduce the adjacent channel interference is to introduce an RF filter at the amplifier output.

This results in a significant expense in terms of equipment costs and a reduction of the available output power due to filter insertion losses.

The present invention is characterised in that it realises clipping at baseband on the signal envelope, which is analogous to the one that would be introduced by the predistorted amplifier.

Such an approach allows for the baseband counteraction of the adjacent channel interference introduced by the clipping circuit itself by means of devices hereinafter defined as "post-clipping filters".

This allows for obtaining the same residual adjacent channel interference for a given output power that would be obtained by using RF selective filters at the amplifier output, with a significant reduction of the system costs.

However, both clipping and post-clipping filtering must be implemented before the predistortion circuit, in order not to vanish the predistorsion action.

In this way, the output of the post-clipping filters represents the baseband equivalent of the best residual distorted signal that can be obtained at the predistorted amplifier output.

In order to clarify the notation used in the description below and in the enclosed figures, we remind that a generic modulated RF signal $x(t)$ at a frequency of $f_0 = \omega_0/2\pi$ can be analytically represented by the following expression:

$$x(t) = R_x(t)\cos\{\omega_0 t + \theta_x(t)\}$$

where $R_x(t)$ and $\theta_x(t)$ represent the instantaneous envelope and the instantaneous phase of the modulating signal, respectively.

The signal can be equivalently represented at baseband by the complex signal $\hat{x}(t)$ that is defined in polar notation as:

$$\hat{x}(t) = R_x(t) \cdot e^{j\theta_x(t)}$$

The complex signal $\hat{x}(t)$ can also be represented by its Cartesian notation as:

$$\hat{x}(t) = x_I(t) + jx_Q(t)$$

where $x_I(t)$ and $x_Q(t)$ are the so-called In-phase and Quadrature signal components, respectively, and are related to the polar notation by the following expressions:

$$x_I(t) = R_x(t) \cdot \cos[\theta_x(t)]$$

$$x_Q(t) = R_x(t) \cdot sen[\theta_x(t)]$$

The relationship between the RF modulated signal and its complex baseband equivalent is expressed by the following analytical expression:

$$x_{RF}(t) = \mathrm{Re}\{\hat{x}(t) \cdot e^{j\omega_0 t}\} = x_I(t)\cos\omega_0 t - x_Q(t)\sin\omega_0 t$$

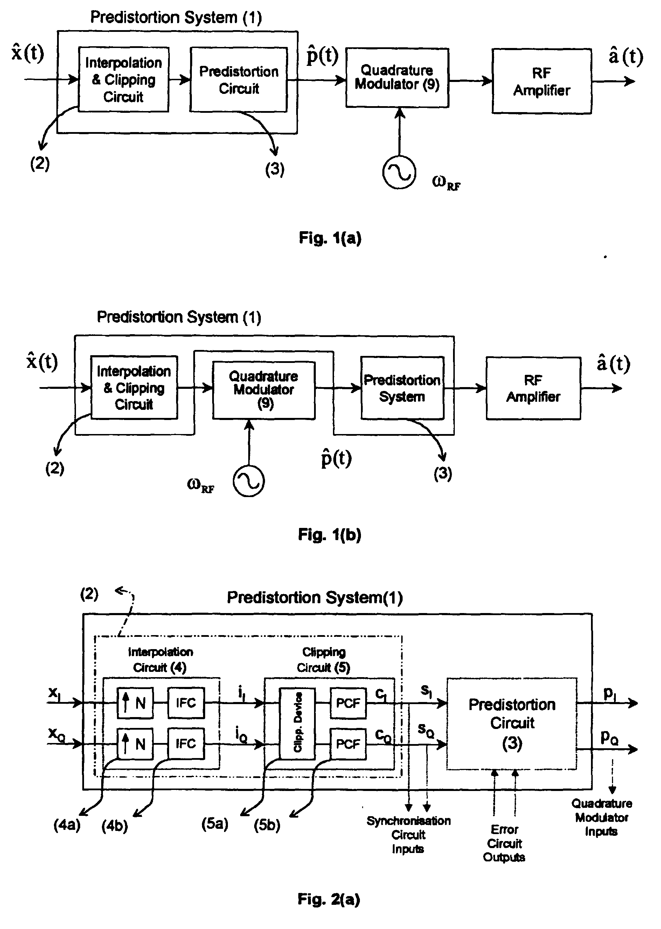

For major clarity the description continues with the architecture of a possible, but not limiting, predistortion system that exploits the present invention. The description will refer to the complex baseband signal representation with reference to the enclosed Figures 1(a) to 6.

Fig. 1(a) shows the scheme of an amplification system that makes use of a baseband Predistortion System (1), which combines the use of a Clipping and Interpolation Circuit (2) with a Predistortion Circuit (3).

If the Predistortion Circuit (3) works at RF rather than at baseband, the amplification system scheme is exactly equivalent to the Quadrature modulation Circuit (9) that is positioned before the Predistorsion Circuit (3), as shown in Fig. 1(b).

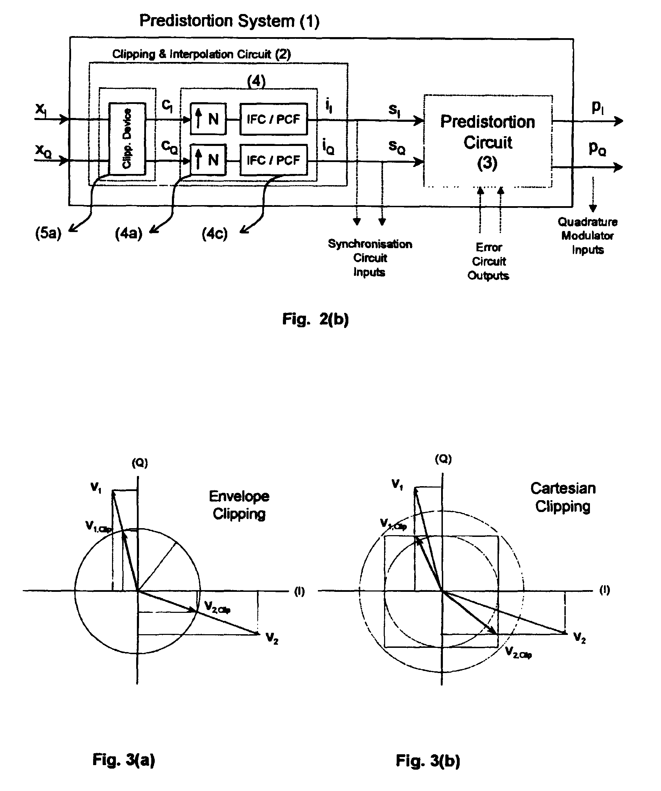

Fig. 2(a) shows the scheme of the Predistortion System (1) in which an Interpolation Circuit (4) is positioned before a Clipping Circuit (5), which in turn is positioned before the Predistortion Circuit (3).

Specifically, the Interpolation Circuit (4) can be realised by means of a Filling Circuit (4a) that inserts (N-1) zeros, or (N-1) replica of each sample between the signal input samples, with N being the interpolation factor. The real interpolation function is performed in cascade through the action of the Interpolation Filter Circuit (IFC) (4b).

The signal that has been interpolated in such a way is elaborated by the Clipping Circuit (5) which firstly limits its maximum envelope (by means of the Clipping Device (5a)) and then eliminates the out-band spectral regrowth (by means of the Post Clipping Filters Circuit (PCF) (5b)).

Fig. 2(b) shows a scheme of the Predistorsion System (1) that is an alternative to Fig. 2(a). In this case an Interpolation & Clipping Circuit (2) firstly performs the Clipping action by means of the Clipping Device (5a), which is followed in cascade by a Filling Circuit (4a) that introduces zeros or input sample replica.

The Filling Circuit (4a) is followed by the Filtering Circuit (4c) that simultaneously realises both the real interpolation filtering (IFC) and the post clipping filtering (PCF) of the signal outband spectral regrowth.

Fig. 3(a) and 3(b) graphically show the clipping operation performed by the Clipping Device (5a) on two general complex signals

$$V_{1,2} = V_{I_{1,2}} + jV_{Q_{1,2}}.$$

Fig. 3(b) and 3(a) represent the action of a Cartesian Clipping Device and the action of an Envelope Clipping Device, respectively. The first device separately cuts each one of the single components ($V_I$, $V_Q$) over a certain value, while the second device jointly works on the single components ($V_I$, $V_Q$) by cutting them in such a way that the envelope is lower than a certain threshold).

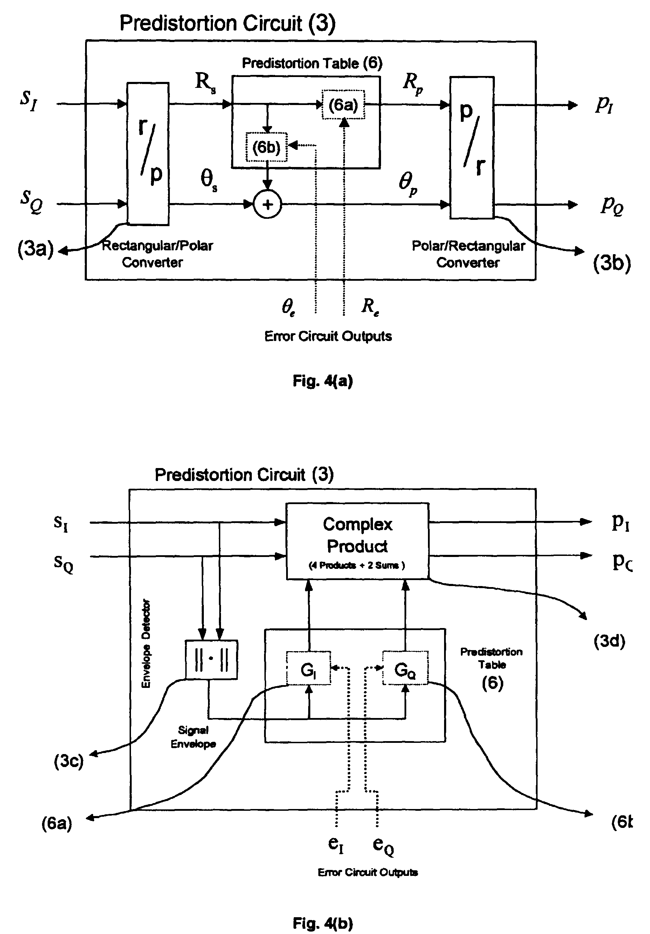

Fig. 4(a) and 4(b) show two possible logical schemes to implement the base band Predistortion Circuit (3). The scheme illustrated in Fig. 4(a) includes the use of a Device (3a) to realise the signal conversion from the Cartesian representation $\hat{s}(t) = s_I(t)+js_Q(t)$ to the polar representation

$$\hat{s}(t) = R_s(t)e^{j\theta_s(t)}.$$

The envelope $R_s(t)$ of this signal is used to address the Predistortion Table (6). The Predistortion Table (6) is organised in two Tables (6a) and (6b). When using the scheme in Fig. 4(a), the signal envelope $R_p(t)$ values of the Predistortion Circuit (3) output are memorised in Table (6b) while the predistortion phase values are memorised in Table (6b). The phase values will provide the predistortion signal phase values $\theta_p(t)$ after they have been added to the input signal phase $\theta_p(t)$. The envelope $R_p(t)$ and the phase $\theta_p(t)$ of the predistortion signal obtained in this way are elaborated by the Device (3b), which reconverts the predistortion signal into its Cartesian components $p_I(t)$ and $p_Q(t)$.

The alternative scheme in Fig. 4(b), which works directly on the Cartesian components $s_I(t)$ and $s_Q(t)$ of the input signal, performs the predistortion through a complex product of the input signal $\hat{s}(t)$ with the complex signal whose Cartesian components are the Predistortion Table (6) outputs.

When using the scheme in Fig. 4(b), the content of the Tables 6(a) and 6(b) is such that the analytical operation performed on the input signal is equivalent to the one introduced by the Circuit (3) in Fig. 4(a).

Fig. 5 represents the conceptual scheme of an amplification system that includes the adaptation of a baseband predistortion system. The scheme includes the use of a Synchronisation Circuit (8) for the synchronisation of the Predistortion Circuit (3) input signal $\hat{s}(t)$ with the RF amplifier output signal $\hat{a}(t)$.

A circuit (7) is also employed to determine the input-output error signal.

Fig. 6 represents the logical scheme of a possible realisation of the Error Circuit (7) when the Predistortion Circuit (3) is realised according to the scheme in Fig. 4(a).

The signal $\hat{x}(t)$ in Fig.1 represents a complex digital signal at the input to the Predistortion System (1).

The signal $\hat{x}(t)$ can be eventually oversampled by the Interpolation Circuit (4) of Fig. 2(a) or by the Circuit (4a) of Fig. 2(b), if the input sample frequency is not high enough to correctly represent it in a non-linear environment. The Clipping Device (5a) shown in Fig. 2(a) or Fig. 2(b) limits the peak-to-mean power ratio of the signal in order to avoid or reduce any other clipping or saturation phenomenon that could be introduced by the Predistortion Circuit (3) and/or the RF Amplifier.

The Clipping Device (5a) reduces the signal peak-to-mean power ratio constraining the envelope of the baseband signal inside a circle of the complex plane, as shown in Fig. 3(a), by a technique that is called Envelope Clipping.

However, it is possible to reduce the peak-to-mean power ratio also by using other clipping strategies. An alternative choice, for example, is to separately clip the In Phase and In Quadrature signal components, as shown in Fig. 3(b), by the technique known as Cartesian Clipping.

The Cartesian Clipping reduces the signal envelope, but also introduces some extra phase distortion on the signal, as shown in Fig. 3(b).

Moreover, the Cartesian Clipping is not exactly matched to the Envelope Clipping introduced by the predistorted amplifier. As a consequence, the predistorted amplifier will introduce further clipping if the complex signal clipping is realised outside to the square circumscribed to the amplifier clipping circle. On the contrary, unneeded extra distortions will be introduced by the Cartesian Clipping if the clipping square is inscribed into the amplifier clipping circle, as shown in Fig. 3 (b).

However the implementation of the Cartesian Clipping is easier and cheaper and consequently it may be considered as a good compromise between performance and costs. Any kind of clipping strategy can be performed before or after the interpolation process (see Fig. 2(a) and Fig. 2(b)) if the Interpolation Circuit (4) is included in the Predistortion & Clipping Circuit (1).

The Clipping Circuit (5) that is placed after the interpolation circuit represents the best solution in terms of achievable performance.

The other approach, however, is characterised by a lower system complexity because the Post Clipping Filters Circuit (4c) acts as interpolation filter also.

The output $\hat{s}(t)$ of the Clipping & Interpolation Circuit (2) represents the input to the Predistortion Circuit (3). The Predistortion Circuit (3) modifies the complex signal components $s_I(t)$ and $s_Q(t)$ generating the components $p_I(t)$ and $p_Q(t)$ so as to introduce the AM/AM and AM/PM distortions that compensate for the ones introduced by the RF Amplifier.

This kind of non linear distortions can be realised in several ways, as reported in [5],[6] and [7].

Both solutions shown in Fig. 4(a) and Fig. 4(b) make us of look-up tables in which the desired distortions are memorised, where the signal envelope $R_s(t)$ is used as unique address in order to reduce the dimensions of the Predistortion Tables (6a) and (6b).

Nevertheless, it is possible to consider any other kind of realisation of the Predistortion Circuit (3) without reducing the efficacy and the originality of the main idea according to the present invention, where the predistorter action is combined and optimised with the clipping strategy.

The Predistortion Circuit (3) shown in Fig. 4(a) is probably one of the most intuitive ones because it directly makes use of the AM/AM and AM/PM distortion curves.

On the contrary, the Predistortion Circuit (3) shown in Fig. 4(b) uses a Complex Gain representation of the non-linear input-output characteristics.

The second approach allows for working with Predistortion Tables (6a) and (6b) that are characterised by lower dimensions, even if the overall system complexity is increased.

The Predistortion Circuit (3) may also adapt the distortion to be introduced, according to the changes of the working conditions caused by amplifier ageing, temperature variations, channel or power switching, and so on.

The purpose of the Error Circuit (7) is to estimate the input-output non-linear error of the predistorted system and provide an error signal $\hat{e}(t)$ to the Predistortion Circuit (3).

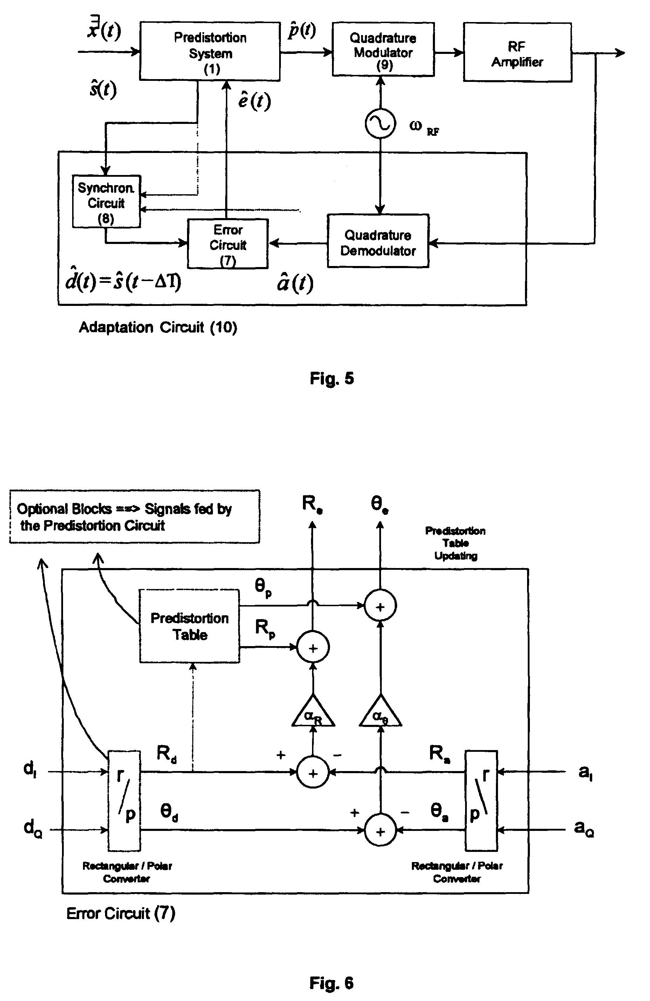

Fig. 6 shows a possible implementation of the error circuit, where the envelope (a scaled replica) and the phase of the Predistortion Circuit (3) input $\hat{s}(t)$ are subtracted from the correspondent amplifier output $\hat{a}(t)$.

The two error signals $R_e(t)$ and $\theta_e(t)$ obtained in this way are subsequently weighted by two real coefficients $\alpha_R$ and $\alpha_\theta$ in order to provide the correcting terms for the action of the Predistortion Circuit (3).

The error signals are used as correcting term for the values memorised in Table (6a) and (6b) respectively, if the Predistortion Circuit is realised according to the scheme in Fig. 4(a).

The two error signals are analytically expressed by:

$$R_e = \alpha_R \cdot [R_a - G \cdot R_d]$$

$$\theta_e = \alpha_\theta \cdot [\theta_a - \theta_d]$$

where G represents the desired linear gain for the predistorted amplifier.

The algorithm has to be likewise implemented in Cartesian co-ordinates if the Predistortion System (1) makes use of the Predistortion Circuit (3) shown in Fig. 4(b).

The magnitude of the adaptation coefficients $\alpha_R$ and $\alpha_\theta$ must be chosen as a compromise between adaptation speed and noise rejection.

The purpose of the Synchronisation Circuit (8) is to estimate the loop delay of the adaptive system and compensate it in order to allow the Error Circuit (7) to correctly compare the input $\hat{s}(t)$ of the Predistortion Circuit (3) with

the output $\hat{a}$ ($t$) of the amplifier.

## REFERENCES

[1] N.M. Blachman, "Bandpass Nonlinearities.", IEEE Trans. on Inform. Theory, VOL. IT-10, April 1964, pp. 162-164.

[2] A.R. Kaye, D.A. George, M.J. Eric, "Analysis and Compensation of Bandpass Nonlinearities for Communications.", IEEE Trans. on Comm., VOL. COM-20, October 1972, pp. 965-972.

[3] P. Hetrakul, D.P. Taylor, "Compensation For Bandpass Nonlinearities in Satellite Communications", IEEE Trans. on Aerosp. Electr. Systems, Vol. AES-12 n.4, July 1976, pp. 509-514.

[4] A.A.M.Saleh and J.Salz, "Adaptive Linearisation of Power Amplifiers in Digital Radio Systems", The Bell Syst. Tech. Journal, Vol. 62, No. 4, April 1983, pp. 1019-1033.

[5] M. Faulkner, M. Johansson, "Adaptive Linearization Using Predistortion - Experimental Results", IEEE Trans. on Veh. Tech., Vol. VT-43 n.2, May. 1994, pp. 323-332.

[6] A. Wright, W. Durtler, "Experimental Performance of an Adaptive Digital Linearized Power Amplifier", IEEE Trans. on Veh. Tech. Vol. VT-41 n.4 Nov. 1992, pp. 395-400.

[7] Y.Levy, G. Karam, H. Sari, "Adaptation of a Digital Predistortion Technique based on Intersymbol Interpolation", IEEE Proc. GLOBECOM '95, pp. 145-150.

## Claims

1. A predistortion system for amplifier linearisation characterised by the fact that it comprises a predistortion circuit (3) in cascade to a clipping circuit (5) composed of at least one clipping device (5a) followed by at least one post-clipping filter device (5b)

2. According to claim 1, a system characterised by the fact that it employs at least one predistortion table (6).

3. According to claim 1, a system characterised by the fact that it employs at least one interpolation circuit (4) of the signal.

4. According to claim 3, a system characterised by the fact that the interpolation circuit is realised through a circuit (4a) for the insertion of zeros or replica of the first sample between successive samples of the signal, with the circuit (4a) that is followed by an interpolation filters circuit (4b) or (4c).

5. According to claim 3, a system characterised by the fact that the clipping device (5a) is positioned before the interpolation circuit (4) and in which the post-clipping filters device (4c) acts as interpolation filters.

6. According to claim 3, a system characterised by the fact that the clipping circuit (5) is positioned after the interpolation circuit (4).

7. According to claim 2, a system characterised by the fact that it employs an adaptation circuit (10) composed of a synchronisation circuit (8) at least and of an error circuit (7) which generates one error signal at least in order to update the predistortion tables (6).

8. According to claim 2, a system characterised by the fact that the predistortion tables (6) are addressed by the signal at the input of the predistortion circuit (3).

9. According to claim 1, a system characterised by the fact that clipping device (5a) limits the envelope of the signal, leaving its phase unchanged.

10. According to claim 1, a system characterised by the fact that the clipping device (5a) separately limits the two Cartesian components of the signal, therefore limiting its envelope and altering its phase.

11. According to claim 7, a system characterised by the fact that the error circuit (7) generates at least one of the error signal by the subtraction of the envelope and the phase of the amplifier baseband output signal from the corresponding components, at most scaled by a multiplicative coefficient, at the input to the predistortion circuit (3).

**12.** According to claim 7, a system characterised by the fact that each error signal is multiplied by at least one weighting coefficient.

**13.** According to claim 7, a system characterised by the fact that each value of the predistortion tables (6) is updated, for each value of their address, by summing to their original content the value of the error signal or a temporal mean performed on a number of values, that is greater or equal to one, that are consecutively assumed by the error signal for each address value.

## Predistortion System (1)

$\hat{x}(t)$ → | Interpolation & Clipping Circuit | → | Predistortion Circuit | → $\hat{p}(t)$ → | Quadrature Modulator (9) | → | RF Amplifier | → $\hat{a}(t)$

(2) (3) $\omega_{RF}$

**Fig. 1(a)**

## Predistortion System (1)

$\hat{x}(t)$ → | Interpolation & Clipping Circuit | → | Quadrature Modulator (9) | → | Predistortion System | → | RF Amplifier | → $\hat{a}(t)$

(2) $\omega_{RF}$ $\hat{p}(t)$ (3)

**Fig. 1(b)**

## Predistortion System(1)

(2)

**Interpolation Circuit (4)** — **Clipping Circuit (5)**

$x_I$ → ↑N → IFC → $i_I$ → Clipp. Device → PCF → $c_I$ → $s_I$ → | Predistortion Circuit (3) | → $p_I$

$x_Q$ → ↑N → IFC → $i_Q$ → Clipp. Device → PCF → $c_Q$ → $s_Q$ → $p_Q$

(4a) (4b) (5a) (5b) Synchronisation Circuit Inputs / Error Circuit Outputs / Quadrature Modulator Inputs

**Fig. 2(a)**

Predistortion System (1)

Fig. 2(b)

Fig. 3(a)

Fig. 3(b)

## Predistortion Circuit (3)

### Predistortion Table (6)

$S_I$

$R_s$ → (6a) → $R_p$ → $p_I$

$\dfrac{r}{p}$

(6b)

$S_Q$

$\theta_s$ (+) $\theta_p$ $\dfrac{p}{r}$ $p_Q$

(3a) ← Rectangular/Polar Converter

Polar/Rectangular Converter → (3b)

$\theta_e$ $R_e$

Error Circuit Outputs

**Fig. 4(a)**

## Predistortion Circuit (3)

$s_I$ → Complex Product (4 Products + 2 Sums) → $p_I$

$s_Q$ → $p_C$

Envelope Detector

$\| \cdot \|$

$G_I$   $G_Q$   Predistortion Table (6)

(3d)

(3c)

Signal Envelope

(6a)

(6t

$e_I$   $e_Q$

Error Circuit Outputs

**Fig. 4(b)**

**Fig. 5**

**Fig. 6**